Europäisches Patentamt

European Patent Office

Office européen des brevets

(11) Numéro de publication: **0 369 913**

**A1**

## (12) DEMANDE DE BREVET EUROPEEN

(21) Numéro de dépôt: **89440124.9**

(22) Date de dépôt: **16.11.89**

(51) Int. Cl.5: **H01J 37/18, H01J 37/20**

(30) Priorité: **18.11.88 FR 8815221**

(43) Date de publication de la demande:
**23.05.90 Bulletin 90/21**

(84) Etats contractants désignés:
**AT BE CH DE ES FR GB GR IT LI LU NL SE**

(71) Demandeur: **CHAIXMECA, Sàrl**
**14, rue Jean Jaurès**
**F-54320 Maxeville(FR)**

(72) Inventeur: **Clement, José**
**rue des Jardins Chambrey**
**F-57170 Chateau Salins(FR)**
Inventeur: **Guerard, Daniel**
**23, rue Chanoine Boulanger**
**F-54220 Malzeville(FR)**

(74) Mandataire: **Nuss, Pierre et al**
**10, rue Jacques Kablé**
**F-67000 Strasbourg(FR)**

(54) **Dispositif pour le transfert et des réactions in-situ sous atmosphère contrôlée d'échantillons destinés à l'examen en microscopie électronique en transmission.**

(57) La présente invention concerne un dispositif pour le transfert et des réactions in-situ sous atmosphère contrôlée d'échantillons destinés à l'examen en microscopie électronique en transmission, caractérisé en ce qu'il est pourvu, en outre, d'un moyen (7) de guidage et de blocage en positions de transport et d'analyse de la tige (1) munie des portegrilles (2), ladite tige (1) étant avantageusement solidarisée par vissage avec l'extrémité correspondante de la barre de traction (5) qui est guidée dans le fourreau (3), dont l'ouverture (9) de la partie avant (3′) de plus faible diamètre est prolongée, sur une portion de la longueur de cette partie avant (3′), de part et d'autre, par des rainures longitudinales (10), ladite partie avant (3′) étant raccordée au reste du fourreau (3) par vissage d'une portion épaulée (11), un joint (13′) réalisant l'étanchéité au niveau de l'assemblage vissé.

Fig.1

## Dispositif pour le transfert et des réactions in-situ sous atmosphère contrôlée d'échantillons destinés à l'examen en microscopie électronique en transmission

La présente invention concerne le domaine de l'examen en microscopie électronique en transmission, en particulier sous atmosphère contrôlée, d'échantillons, notamment de composés d'insertion du graphite et a pour objet un dispositif pour le transfert et des réactions in-situ sous atmosphère contrôlée d'échantillons destinés à de tels examens. Ce dispositif peut également être utilisé pour procéder, soit à l'intérieur même de la chambre du microscope, soit dans le sas de celui-ci, à des réactions chimiques entre le ou les échantillons posés sur la ou les grilles et des gaz de nature, composition, pression et température contrôlées, ce qui particulièrement utile pour la réalisation d'une étude cinétique de ces réactions.

Les composés d'insertion du graphite sont soumis, depuis un certain nombre d'années, à une étude très approfondie, notamment en raison, d'une part, de leur conductibilité électrique parallèlement aux feuillets de graphène, qui est très élevée à température ambiante et pour certains voisine de celle du cuivre, alliée à une grande anisotropie qui peut aller jusqu'à $10^6$, d'autre part, du caractère supraconducteur de certains composés pouvant atteindre la température de l'hélium liquide et, enfin, de la grande variété des espèces qui peuvent être insérées entre les feuillets de graphène, à savoir des métaux alcalins aux halogènes en passant par des alliages métalliques, des hydrures alcalins, les alcalino-terreux, certains lanthanoïdes, des acides, des halogénures ou oxyhalogénures de métaux de transition, etc...

La classe des composés d'insertion du graphite comporte actuellement 300 à 400 phases différentes en prenant en considération le phénomène des stades. Ainsi, un composé est dit de stade 1, 2, 3... selon que deux feuillets insérés successifs sont séparés par 1, 2, 3... couches de graphite. Dans certains cas, le stade peut atteindre la valeur 12 ou 13.

La grande variété de réactifs confère aux composés d'insertion des propriétés diverses justifiant amplement les études approfondies qui leur sont consacrées.

Les composés d'insertion présentent souvent des transitions de phase qui sont décelées par des variations de résistivité électrique ou de dilatation thermique. Dans un grand nombre de composés, il existe, en outre, une incommensurabilité entre réseau hôte et réseau inséré et les réflexions obtenues sont parfois de très faible intensité lorsqu'on les étudie aux rayons X.

A cet effet, il est particulièrement intéressant de pouvoir étudier ces composés par toutes les méthodes d'investigations possibles, et, plus particulièrement, par microscopie électronique par transmission.

De telles méthodes d'investigation sont, cependant, difficiles à mettre en oeuvre, du fait que les composés d'insertion sont, en majorité, très fragiles à l'air, de sorte que se pose le problème du transfert des échantillons dans la chambre d'un microscope électronique.

En effet, l'accent a été mis sur les composés d'insertion du graphite pour lesquels un transfert sous atmosphère contrôlée se révèle indispensable. Les porte-échantillons connus sont bien évidemment utilisables pour tous types de matériaux dont les caractéristiques géométriques, en particulier l'épaisseur, sont compatibles avec l'observation, par transmission, en microscopie électronique. Ils permettent, en outre, de positionner des échantillons, même non fragiles à l'air de les faire pénétrer dans la chambre de réaction du porte-échantillon après une première étude au microscope électronique, de les faire réagir ensuite et de les analyser sans avoir recours à d'autres appareillages et, surtout, sans qu'ils aient été remis au contact de l'air.

Ainsi, il n'existe pas, actuellement, de porte-échantillons adaptable à tous types de microscopes électroniques à entrée latérale, qui permette à la fois un transfert d'échantillons sous atmosphère contrôlée et des réactions in-situ. Cette dernière notion est très importante, du fait qu'elle permet de réaliser des réactions chimiques lorsque le porte-échantillons est à l'intérieur même de la chambre du microscope et la tige porte-grilles est en position dite de transport.

Il se pose donc un problème d'introduction d'une grille de microscope, préparée préalablement dans une boîte à gants à atmosphère contrôlée, dans la chambre d'étude d'un microscope électronique, sans qu'elle puisse être en contact avec l'air. A cet effet, une tige renfermant le porteéchantillons, pouvant être de diamètres variables et munie d'un téton servant à manoeuvrer son ouverture vers les pompes à vide, puis vers la porte du sas du microscope, doit pénétrer dans ledit sas sur une longueur d'environ 20 cm.

La protection de l'échantillon par un chemisage extérieur et des études cinétiques pourraient être réalisées grâce à un appareillage monté sur une bride de raccordement avec le sas du microscope entraînant une modification de celui-ci.

Une telle modification, outre qu'elle serait gênante, entraînerait un rallongement du porte-échantillons incompatible avec la taille de la plupart des sas de boîtes à gants.

Il serait également possible de construire une boîte à gants montée directement sur la sortie du sas du microscope moyennant une modification de ce dernier. Un tel mode de réalisation est, toutefois, assez compliqué.

On connaît, par ailleurs, un dispositif de transfert dont la partie avant est munie d'un joint extérieur venant se loger à l'intérieur de la chambre du microscope. Ce dispositif présente, cependant, un certain nombre d'inconvénients, à savoir, d'une part, un risque de détérioration du joint lors du coulissement de la partie mobile du porte-échantillons entre les rails de guidage du porte-objet, d'autre part, un défaut de maîtrise de la position parfaite de l'objet à l'intérieur de la chambre du fait que le guidage du mouvement dans cette dernière est effectué par l'intermédiaire d'un joint élastique et, enfin, la prévision d'un seul logement de grille sur le porte-objet, ce qui entraîne des opérations relativement longues de chargement de la grille pour chaque échantillon.

La présente invention a pour but de pallier ces inconvénients.

Elle a, en effet, pour objet un dispositif pour le transfert et des réactions in-situ sous atmosphère contrôlée d'échantillons destinés à l'examen en microscopie électronique en transmission, essentiellement constitué par une tige cylindrique de faible diamètre comportant, près d'une extrémité, deux porte-grilles et montée à coulissement dans un fourreau de plus gros diamètre muni d'une chambre étanche de logement des porte-grilles en position de transport, par une barre de traction solidaire de l'extrémité de la tige de faible diamètre opposée aux porte-grilles, guidée dans le fourreau de plus gros diamètre et pourvue à son autre extrémité d'un bouton de manoeuvre, les porte-grilles étant avantageusement ménagés dans un méplat de l'extrémité de la tige et le fourreau étant avantageusement réalisé en deux parties et présentant une partie avant de plus faible diamètre destinée à pénétrer dans le sas du microscope et pourvue d'une ouverture longitudinale correspondant au moins à la section des porte-grilles de la tige en position d'analyse de cette dernière, caractérisé en ce qu'il est pourvu, en outre, d'un moyen de guidage et de blocage en positions de transport et d'analyse de la tige munie des porte-grilles, ladite tige étant avantageusement solidarisée par vissage avec l'extrémité correspondante de la barre de traction qui est guidée dans le fourreau, dont l'ouverture de la partie avant de plus faible diamètre est prolongée, sur une portion de la longueur de cette partie avant, de part et d'autre, par des rainures longitudinales, ladite partie avant étant raccordée au reste du fourreau par vissage d'une portion épaulée, un joint réalisant l'étanchéité au niveau de l'assemblage vissé.

L'invention sera mieux comprise grâce à la description ci-après, qui se rapporte à un mode de réalisation préféré, donné à titre d'exemple non limitatif, et expliqué avec référence au dessin schématique annexé, dans lequel :

la figure 1 est une vue en plan et partiellement en coupe du dispositif conforme à l'invention ;

la figure 2 est une vue en élévation latérale, en coupe et à plus grande échelle, de la tige munie des porte-grilles, et

la figure 3 est une vue en plan, à plus grande échelle, de la tige selon la figure 2 et de l'extrémité du fourreau logeant cette dernière et pénétrant dans le sas du microscope.

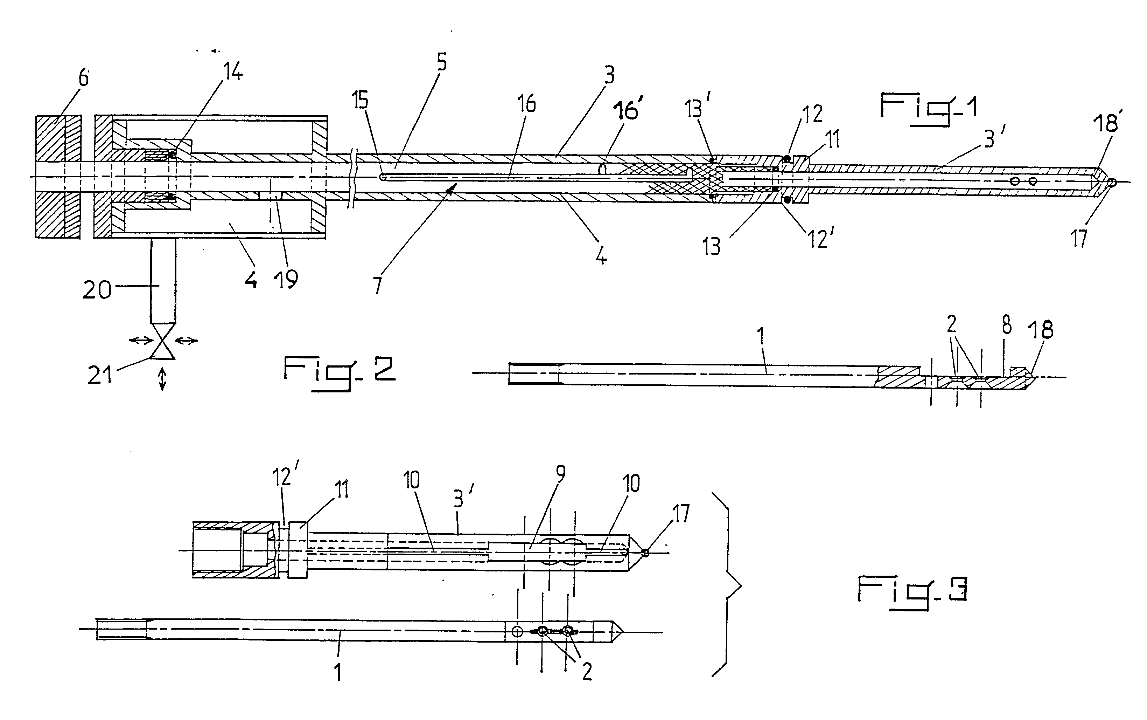

Conformément à l'invention, et comme le montre plus particulièrement, à titre d'exemple, la figure 1 du dessin annexé, le dispositif pour le transfert et des réactions in-situ sous atmosphère contrôlée d'échantillons destinés à l'examen en microscopie électronique en transmission, qui est essentiellement constitué par une tige cylindrique 1 de faible diamètre comportant, près d'une extrémité, deux porte-grilles 2 et montée à coulissement dans un fourreau 3 de plus gros diamètre muni d'une chambre étanche 4 de logement des porte-grilles 2 en position de transport, par une barre de traction 5 solidaire de l'extrémité de la tige 1 de faible diamètre opposée aux porte-grilles 2, guidée dans le fourreau 3 de plus gros diamètre et pourvue à son autre extrémité d'un bouton de manoeuvre 6, les porte-grilles 2 étant avantageusement ménagés dans un méplat 8 de l'extrémité de la tige 1 et le fourreau 3 étant avantageusement réalisé en deux parties et présentant une partie avant 3′ de plus faible diamètre destinée à pénétrer dans le sas du microscope et pourvue d'une ouverture longitudinale 9 correspondant au moins à la section des porte-grilles de la tige 1 en position d'analyse de cette dernière, est caractérisé en ce qu'il est pourvu, en outre, d'un moyen 7 de guidage et de blocage en positions de transport et d'analyse de la tige 1 munie des porte-grilles 2, ladite tige 1 étant avantageusement solidarisée par vissage avec l'extrémité correspondante de la barre de traction 5 qui est guidée dans le fourreau 3, dont l'ouverture 9 de la partie avant 3′ de plus faible diamètre est prolongée, sur une portion de la longueur de cette partie avant 3′, de part et d'autre, par des rainures longitudinales 10, ladite partie avant 3′ étant raccordée au reste du fourreau 3 par vissage d'une portion épaulée 11, un joint 13 réalisant l'étanchéité au niveau de l'assemblage vissé (figures 1 et 3).

La prévision des rainures longitudinales 10 permet une mise sous vide progressive des échantillons montés sur les porte-grilles 2 lors du coulissement en position d'analyse de la tige 1 dans le sas du microscope.

Conformément à une caractéristique de l'invention, la partie arrière du fourreau 3, près du bouton de manoeuvre 6, est avantageusement entourée par un manchon 22 délimitant une chambre étanche reliée à la chambre 4 par l'intermédiaire d'un trou 19 prévu dans ladite partie arrière du fourreau 3, ladite chambre étant elle-même reliée, par l'intermédiaire d'un tube 20, à une vanne multivoies 21.

Le fourreau 3 est pourvu, en outre, d'une part, près de sa portion épaulée 11, d'un joint d'étanchéité externe 12 logé dans une gorge 12' et destiné à coopérer avec l'orifice de passage du sas du microscope et, d'au tre part, d'un joint interne 13 délimitant, avec un joint 14, prévu à l'extrémité opposée du fourreau 3, d'étanchéité et de guidage de l'extrémité opposée de la barre 5, le joint 13' et la vanne multivoies 21, située à l'extrémité du tube 20, perpendiculaire au manchon 22, la chambre étanche 4 (figure 1).

La barre de traction 5 est munie du moyen 7 de guidage et de blocage en positions de transport, de réaction et d'analyse de la tige 1, qui est constitué par un téton de guidage 15 coopérant avec une rainure de guidage longitudinale 16 prévue dans le fourreau 3, cette rainure 16 présentant une partie à angle droit à ses extrémités et une partie intermédiaire 16' et permettant le blocage du téton 15 dans les positions d'analyse, de transport et de réaction de la tige 1. La partie intermédiaire 16' permet d'arrêter la barre 5 dans une position où il est possible de réaliser un vide dans la chambre 4 par l'intermédiaire du sas du microscope.

L'échantillon mis en place sur les porte-grilles 2 de la tige 1 sous atmosphère contrôlée dans la boîte à gants à circulation de gaz est ensuite protégé de l'atmosphère extérieure par rétraction de la tige 1 à l'intérieur de la chambre étanche 4 du fourreau 3 au moyen de la barre de traction 5. Le dispositif se trouve alors en position fermée permettant le transport de échantillon sur les grilles.

Grâce à la vanne multivoies 21, il est possible de réaliser, dans un premier temps, le vide dans la chambre étanche 4 et de remplacer l'atmosphère initiale par une autre atmosphère, dont on peut contrôler la nature, la composition, la pression et la température afin de réaliser une réaction de cette atmosphère avec échantillon. Une telle opération peut être répétée plusieurs fois, de façon à établir, par exemple, une cinétique de la réaction. Il est possible de faire circuler le gaz réactif dans la chambre 4 en maintenant le fourreau 3 en position de "pompage dans le sas". Si l'atmosphère réactive est susceptible d'être agressive vis à vis du sas ou du groupe de pompage du microscope, il est nécessaire, en fin d'opération, de réaliser le vide dans la chambre 4 par l'intermédiaire de la vanne 21.

Le verrouillage en position fermée ou de réaction est assuré par une légère rotation de la tige 1 et donc de la barre 5 au moyen du bouton de manoeuvre 6. par exemple de 10°, amenant le téton 15 au fond de la partie à angle droit de l'extrémité correspondante de la rainure 16 ou de la partie intermédiaire 16'.

Selon une autre caractéristique de l'invention, la partie avant 3' du fourreau 3 est munie, à son extrémité libre, d'un rubis 17 destiné à coopérer avec une partie conique femelle de guidage prévue dans la chambre d'étude du microscope. Ainsi, l'extrémité du fourreau 3 peut être parfaitement positionnée dans ladite chambre du microscope, dans les positions d'analyse des porte-grilles 2.

Conformément à une variante de réalisation de l'invention, le rubis 17 peut être monté solidaire de la partie conique femelle de guidage prévue dans la chambre d'étude du microscope, seule la tige 1 étant manipulée et son centrage étant assuré, d'une part, par le cône extérieur de la partie avant du fourreau 3 et, d'autre part, par le cône 18 de l'extrémité libre de la tige 1 coopérant avec le cône intérieur 18' correspondant du fourreau 3. Ainsi, il est possible de réaliser un repositionnement parfait de l'échantillon après réaction et étude de l'évolution d'une particule donnée après des durées variables d'exposition à un gaz réactif.

Dans le cas où une étude de réaction n'est pas prévue, le dispositif peut alors être introduit par la partie avant du fourreau 3 dans le sas du microscope avec réalisation de l'étanchéité au moyen du joint externe 12. Après atteinte de la valeur normale de vide dans le sas, la tige 1 est partiellement coulissée à l'intérieur du fourreau 3, hors de la chambre étanche 4, afin d'obtenir la même valeur de vide au niveau des porte-grilles 2. Une telle ouverture est réalisée dans une position intermédiaire du téton 15 dans la rainure 16. Ensuite, les porte-grilles 2 avec le ou les échantillons sont amenés dans la position d'analyse de la tige 1 avec verrouillage dans cette position par légère rotation dans la partie à angle droit de l'extrémité correspondante de la rainure 16, la porte intérieure du sas du microscope est ouverte, et l'ensemble est enfoncé dans la chambre d'étude du microscope.

Grâce à l'invention, il est possible de maintenir un vide correct aussi bien dynamique, dans le corps du microscope, que statique, dans le sas, permettant obtention de bonnes conditions de travail.

En outre, le dispositif conforme à l'invention ne nécessite aucune adaptation du microscope électronique lui-même ni des dimensions extérieures du porte-échantillons. Enfin, l'étanchéité de la chambre logeant les échantillons pendant le transport et la réaction étant assurée par des joints internes au dispositif, ne venant donc pas en contact avec des pièces du microscope, la dégradation de ces joints est évitée et le guidage du dispositif à l'intérieur de la chambre d'étude du microscope peut s'effectuer sans entrave, donc de manière plus précise.

Enfin, l'invention permet de réaliser un dispositif pour le transfert et la réaction in-situ sous atmosphère contrôlée d'échantillons destinés à l'examen en microscopie électronique en transmission à entrée latérale permettant, d'une part, de maintenir lesdits échantillons sous atmosphère contrôlée en dehors des périodes d'examen dans le microscope et, d'autre part, de réaliser des réactions in-situ entre l'échantillon et un gaz, dont la nature, la composition, la pression et la température peuvent être maitrisées, ledit dispositif étant adaptable sur tous types de microscopes électroniques à entrée latérale sans nécessiter aucune modification ni du microscope, ni de son sas d'entrée.

Bien entendu, l'invention n'est pas limitée au mode de réalisation décrit et représenté au dessin annexé. Des modifications restent possibles, notamment du point de vue de la constitution des divers éléments ou par substitution d'équivalents techniques, sans sortir pour autant du domaine de protection de l'invention.

**Revendications**

1. Dispositif pour le transfert et des réactions in-situ sous atmosphère contrôlée d'échantillons destinés à l'examen en microscopie électronique en transmission, essentiellement constitué par une tige cylindrique (1) de faible diamètre comportant, près d'une extrémité, deux porte-grilles (2) et montée à coulissement dans un fourreau (3) de plus gros diamètre muni d'une chambre étanche (4) de logement des porte-grilles (2) en position de transport, par une barre de traction (5) solidaire de l'extrémité de la tige (1) de faible diamètre opposée aux porte-grilles (2), guidée dans le fourreau (3) de plus gros diamètre et pourvue à son autre extrémité d'un bouton de manoeuvre (6), les porte-grilles (2) étant avantageusement ménagés dans un méplat (8) de l'extrémité de la tige (1) et le fourreau (3) étant avantageusement réalisé en deux parties et présentant une partie avant (3') de plus faible diamètre destinée à pénétrer dans le sas du microscope et pourvue d'une ouverture longitudinale (9) correspondant au moins à la section des porte-grilles de la tige (1) en position d'analyse de cette dernière, caractérisé en ce qu'il est pourvu, en outre, d'un moyen (7) de guidage et de blocage en positions de transport et d'analyse de la tige (1) munie des porte-grilles (2), ladite tige (1) étant avantageusement solidarisée par vissage avec l'extrémité correspondante de la barre de traction (5) qui est guidée dans le fourreau (3), dont l'ouverture (9) de la partie avant (3') de plus faible diamètre est prolongée, sur une portion de la longueur de cette partie avant (3'), de part et d'autre, par des rainures longitudinales (10), ladite partie avant (3') étant raccordée au reste du fourreau (3) par vissage d'une portion épaulée (11), un joint (13') réalisant l'étanchéité au niveau de l'assemblage vissé.

2. Dispositif, suivant la revendication 1. caractérisé en ce que la partie arrière du fourreau (3), près du bouton de manoeuvre (6), est avantageusement entourée par un manchon (22) délimitant une chambre étanche reliée à la chambre (4) par l'intermédiaire d'un trou (19) prévu dans ladite partie arrière du fourreau (3), ladite chambre étant elle-même reliée, par l'intermédiaire d'un tube (20), à une vanne multivoies (21).

3. Dispositif, suivant l'une quelconque des revendications 1 et 2, caractérisé en ce que le fourreau (3) est pourvu, en outre, d'une part, près de sa portion épaulée (11), d'un joint d'étanchéité externe (12) logé dans une gorge (12 ) et destiné à coopérer avec l'orifice de passage du sas du microscope et, d'autre part. d'un joint interne (13) délimitant, avec un joint (14), prévu à l'extrémité opposée du fourreau (3), d'étanchéité et de guidage de l'extrémité opposée de la barre (5), le joint (13') et la vanne multivoies (21), située à l'extrémité du tube (20), perpendiculaire au manchon (22), la chambre étanche (4).

4. Dispositif, suivant l'une quelconque des revendications 1 et 3, caractérisé en ce que la barre de traction (5) est munie du moyen (7) de guidage et de blocage en positions de transport, de réaction et d'analyse de la tige (1), qui est constitué par un téton de guidage (15) coopérant avec une rainure de guidage longitudinale (16) prévue dans le fourreau (3), cette rainure (16) présentant une partie à angle droit à ses extrémités et une partie intermédiaire (16') et permettant le blocage du téton (15) dans les positions d'analyse. de transport et de réaction de la tige (1).

5. Dispositif, suivant l'une quelconque des revendications 1 à 3, caractérisé en ce que la partie avant (3') du fourreau (3) est munie, à son extrémité libre, d'un rubis (17) destiné à coopérer avec une partie conique femelle de guidage prévue dans la chambre d'étude du microscope.

6. Dispositif, suivant l'une quelconque des revendications 1 à 3, caractérisé en ce que le rubis (17) est monté solidaire de la partie conique femelle de guidage prévue dans la chambre d'étude du microscope, seule la tige (1) étant manipulée et son centrage étant assuré, d'une part, par le cône extérieur de la partie avant du fourreau (3), d'autre part, par le cône (18) de son extrémité libre coopérant avec le cône intérieur (18') correspondant du fourreau (3).

Fig-1

Fig-2

Fig-3

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| Y | PATENT ABSTRACTS OF JAPAN, vol. 2, no. 79, 23 juin 1978, page 3219 E 78; & JP-A-53 43 468 (HITACHI) --- | 1 | H 01 J  37/18 H 01 J  37/20 |
| Y | FR-A-2 477 769  (GONCHOND et al.) * Figures; page 1, lignes 6-15; page 2, lignes 15-29 * | 1 | |
| A | | 2-4 | |
| A | DE-A-2 511 449  (LEYBOLD-HERAEUS GmbH) * Figure; pages 2,3 * --- | 1,3 | |
| A | US-A-3 896 314  (NUKUI et al.) * Figures 1,2; colonne 2, lignes 17-40 * ----- | 5,6 | |

| | | | DOMAINES TECHNIQUES RECHERCHES (Int. Cl.5) |
|---|---|---|---|
| | | | H 01 J  37/00 |

Le présent rapport a été établi pour toutes les revendications

| Lieu de la recherche | Date d'achèvement de la recherche | Examinateur |
|---|---|---|
| LA HAYE | 23-02-1990 | SCHAUB G.G. |